# EUROPEAN PATENT APPLICATION

(11) **EP 4 727 265 A1**
(43) Date of publication of application: **15.04.2026**
(21) Application number: 24863135.0
(22) Date of filing: 30.08.2024
(51) Int. Cl.: H05K 1/02, H05K 1/11, H05K 1/14, H04M 1/02

(54) **ELECTRONIC DEVICE INCLUDING FLEXIBLE CIRCUIT BOARD**

(30) Priority: 05.09.2023 KR 20230117468; 10.10.2023 KR 20230134499
(71) Applicant: Samsung Electronics Co., Ltd., Suwon-si, Gyeonggi-do 16677 (KR)
(72) Inventor: LEE, Youngsun, Suwon-si Gyeonggi-do 16677 (KR)
(74) Representative: HGF
(86) International application number: PCT/KR2024/013082
(87) International publication number: WO 2025/053554

(57) **Abstract**

The present invention relates to an electronic device. The electronic device according to an embodiment of the present invention comprises: a housing; a circuit board disposed inside the housing; a camera assembly spaced apart from the circuit board; and a flexible circuit board including a first rigid portion, which is connected to the camera assembly, a second rigid portion, which is connected to the circuit board, and a flexible portion, which connects the first rigid portion and the second rigid portion. The flexible circuit board may include: a base material layer; a first conductive layer coupled to the base material layer; a first shielding layer that is spaced apart from the first conductive layer and includes a 1-1 shielding layer portion located in the first rigid portion, a 1-2 shielding layer portion located in the second rigid portion, and a 1-3 shielding layer portion located in the flexible portion; and a first grounding layer which is connected to the first shielding layer and at least a portion of which extends along the perimeter of the first rigid portion. Various other embodiments are also possible.

## Description

### [Technical Field]

Various embodiments of the disclosure relate to an electronic device, e.g., an electronic device including a flexible circuit board.

### [Background Art]

Advancing information communication and semiconductor technologies accelerate the spread and use of various electronic devices. In particular, recent electronic devices are being developed to carry out communication while carried on.

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, the electronic devices may output stored information as voices or images. As electronic devices are highly integrated, and high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function, such as for mobile banking, and a scheduling or e-wallet function. These electronic devices have been downsized to be conveniently carried by users.

The above-described information may be provided as related art for the purpose of helping understanding of the disclosure. No claim or determination is made as to whether any of the foregoing is applicable as background art in relation to the disclosure.

### [Disclosure of Invention]

### [Solution to Problems]

An electronic device according to an embodiment of the disclosure may comprise a housing.

The electronic device according to an embodiment of the disclosure may comprise a circuit board disposed in the housing.

The electronic device according to an embodiment of the disclosure may comprise a camera assembly spaced apart from the circuit board.

The electronic device according to an embodiment of the disclosure may comprise a flexible circuit board including a first rigid portion connected to the camera assembly, a second rigid portion connected to the circuit board, and a flexible portion connecting the first rigid portion and the second rigid portion.

The flexible circuit board according to an embodiment of the disclosure may include a base layer.

The flexible circuit board according to an embodiment of the disclosure may include a first conductive layer coupled to the base layer.

The flexible circuit board according to an embodiment of the disclosure may include a first shielding layer including a 1-1th shielding layer portion located in the first rigid portion, a 1-2th shielding layer portion located in the second rigid portion, and a 1-3th shielding layer portion located in the flexible portion, and spaced apart from the first conductive layer.

The flexible circuit board according to an embodiment of the disclosure may include a first ground layer at least partially extending along a circumference of the first rigid portion and connected to the first shielding layer.

A flexible circuit board according to an embodiment of the disclosure may comprise a base layer extending to correspond to each of a first rigid portion, a second rigid portion spaced apart from the first rigid portion, and a flexible portion connecting the first rigid portion and the second rigid portion.

The flexible circuit board according to an embodiment of the disclosure may include a first conductive layer coupled to the base layer.

The flexible circuit board according to an embodiment of the disclosure may include a first shielding layer including a 1-1th shielding layer portion located in the first rigid portion, a 1-2th shielding layer portion located in the second rigid portion, and a 1-3th shielding layer portion located in the flexible portion, and spaced apart from the first conductive layer.

The flexible circuit board according to an embodiment of the disclosure may include a first ground layer at least partially extending along a circumference of the first rigid portion and connected to the first shielding layer.

### [Brief Description of Drawings]

FIG. 1 is a block diagram illustrating an electronic device in a network environment according to an embodiment;
FIG. 2 is a perspective view illustrating an electronic device according to an embodiment of the disclosure;
FIG. 3 is a perspective view illustrating an electronic device according to an embodiment of the disclosure;
FIG. 4 is an exploded perspective view illustrating an electronic device according to an embodiment of the disclosure;
FIG. 5 is an exploded perspective view illustrating an electronic device according to an embodiment of the disclosure;
FIG. 6 illustrates a portion of an electronic device according to an embodiment of the disclosure; and
FIG. 7 illustrates a portion of an electronic device according to an embodiment of the disclosure; and
FIG. 8 is a cross-sectional view illustrating a portion of an electronic device according to an embodiment of the disclosure;
FIG. 9 is a cross-sectional view illustrating a portion of an electronic device according to an embodiment of the disclosure;
FIG. 10 illustrates a portion of an electronic device according to an embodiment of the disclosure; and
FIG. 11 is a cross-sectional view illustrating a portion of an electronic device according to an embodiment of the disclosure;
FIG. 12 is a cross-sectional view illustrating a portion of an electronic device according to an embodiment of the disclosure;
FIG. 13A is a cross-sectional view illustrating a portion of an electronic device according to an embodiment of the disclosure;
FIG. 13B is a view illustrating assembly of a flexible circuit board according to an embodiment of the disclosure; and
FIG. 13C is a cross-sectional view illustrating a flexible circuit board according to an embodiment of the disclosure.

### [Mode for the Invention]

The following description taken in conjunction with the accompanying drawings may provide an understanding of various exemplary implementations of the disclosure, including claims and their equivalents. The specific embodiments disclosed in the following description entail various specific details to aid understanding, but are regarded as one of various embodiments. Accordingly, it will be understood by those skilled in the art that various changes and modifications may be made to the various implementations described in the disclosure without departing from the scope and spirit of the disclosure. Further, descriptions of well-known functions and configurations may be omitted for clarity and brevity.

The terms and words used in the following description and claims are not limited to the bibliographical meaning, but may be used to clearly and consistently describe an embodiment of the disclosure. Therefore, it will be apparent to those skilled in the art that the following description of various implementations of the disclosure is provided only for the purpose of description, not for the purpose of limiting the disclosure defined as the scope of the claims and equivalent thereto.

The singular forms "a," "an," and "the" are intended to include the plural forms as well, unless the context clearly indicates otherwise. Thus, as an example, "a component surface" may be interpreted as including one or more of the surfaces of a component.

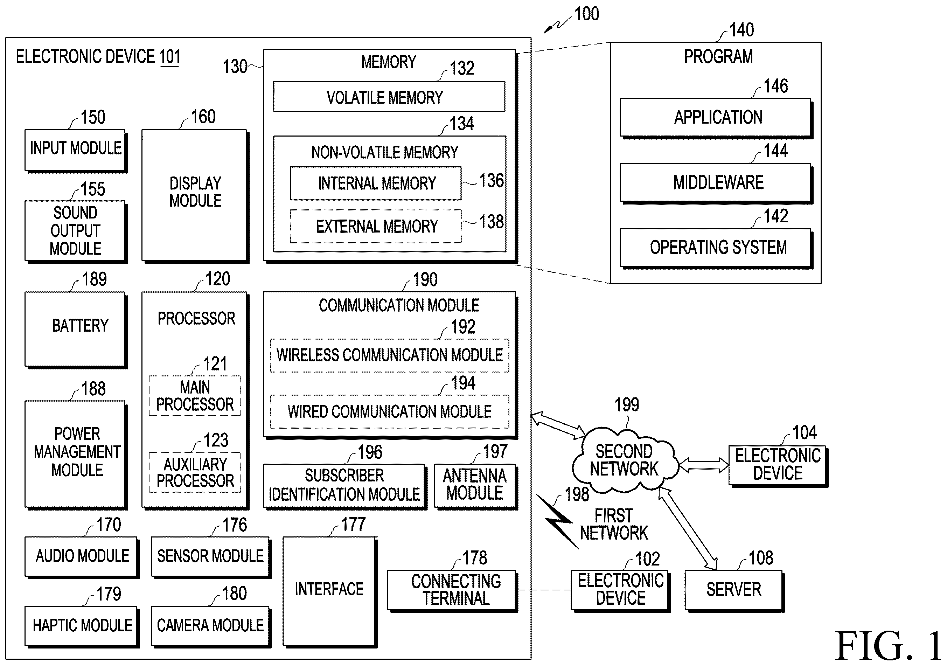

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

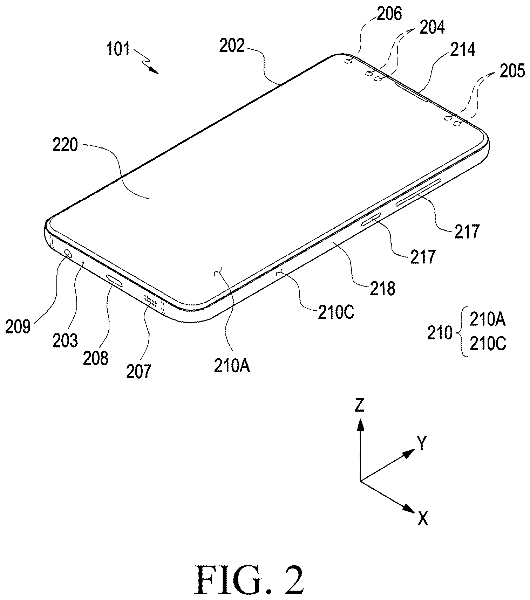

FIG. 2 is a front perspective view illustrating an electronic device according to an embodiment of the disclosure.

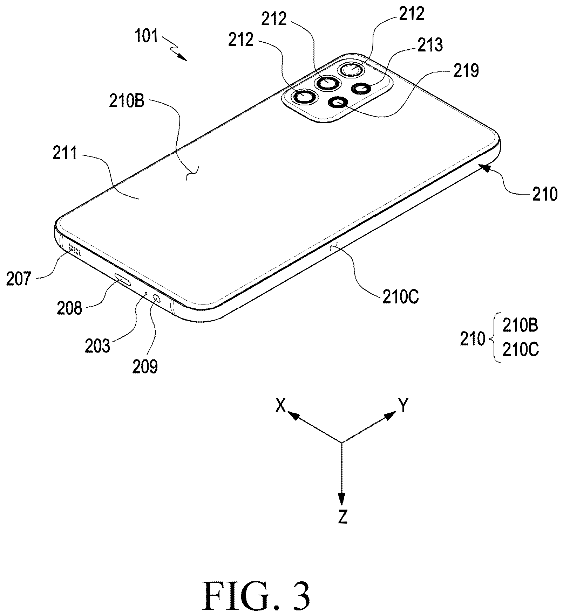

FIG. 3 is a rear perspective view illustrating an electronic device according to an embodiment of the disclosure.

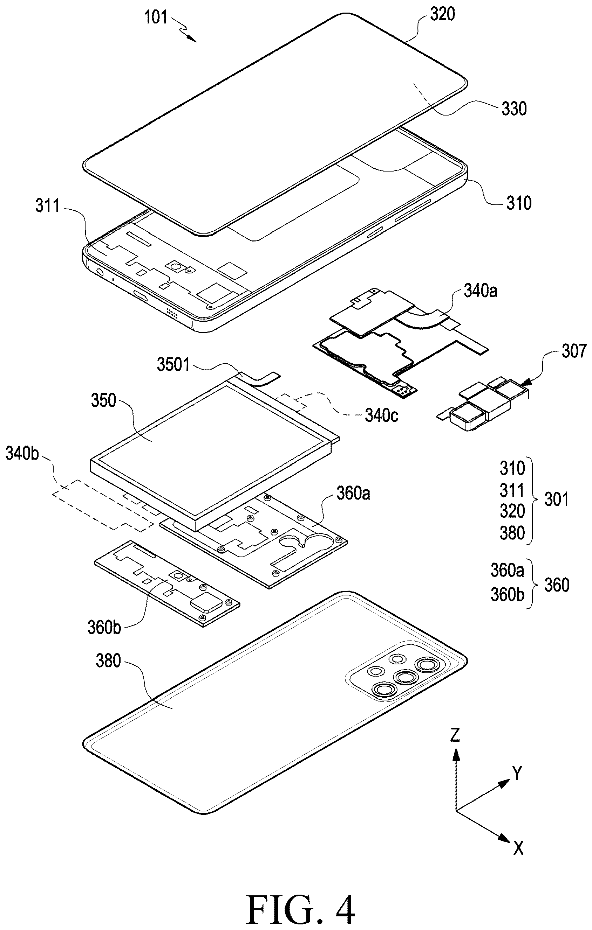

The embodiments of FIGS. 2 and 3 may be combined with the embodiment of FIG. 1 or the embodiments of FIGS. 4 to 13C.

Referring to FIGS. 2 and 3, according to an embodiment, an electronic device 101 (e.g., the electronic device 101 of FIG. 1) may include a housing 210 including a first surface (or front surface) 210A, a second surface (or rear surface) 210B, and a side surface 210C surrounding a space between the first surface 210A and the second surface 210B. According to an embodiment (not illustrated), the housing 210 may denote a structure forming the first surface 210A of FIG. 2, the second surface 210B of FIG. 3, and some of the side surfaces 210C. According to an embodiment, at least part of the first surface 210A may have a substantially transparent front plate 202 (e.g., a glass plate or polymer plate including various coat layers). The second surface 210B may be formed by a rear plate 211 that is substantially opaque. The rear plate 211 may be formed of, e.g., laminated or colored glass, ceramic, polymer, metal (e.g., aluminum, stainless steel (STS), or magnesium), or a combination of at least two thereof. The rear plate 211 may form the second surface 210B. The side surface 210C may be formed by a side structure (or "side bezel structure") 218 that couples to the front plate 202 and the rear plate 211 and includes a metal and/or polymer. In an embodiment, the rear plate 211 and the side structure 218 may be integrally formed together and include the same material (e.g., a metal, such as aluminum).

Although not shown, the front plate 202 may include area(s) that bend from at least a portion of an edge toward the rear plate 211 and seamlessly extend. In an embodiment, only one of the areas of the front plate 202 (or the rear plate 211), which bend to the rear plate 211 (or front plate 202) and extend may be included in one edge of the first surface 210A. According to an embodiment, the front plate 202 or the rear plate 211 may have a substantially flat plate shape. For example, no bent and extended area may be included. When an area bending and extending is included, the thickness of the electronic device 101 at the portion including the area bending and extending may be smaller than the thickness of the rest.

According to an embodiment, the electronic device 101 may include at least one or more of a display 220, audio modules 203, 207, and 214, sensor modules 204 and 219, camera modules 205, 212, and 213, key input devices 217, a light emitting device 206, and connector holes 208 and 209. In an embodiment, the electronic device 101 may exclude at least one (e.g., the key input device 217 or the light emitting device 206) of the components or may add other components.

The display 220 may be visually exposed through a significant portion of the front plate 202. In an embodiment, at least a portion of the display 220 may be visually exposed through the front plate 202 forming the first surface 210A, or through a portion of the side surface 210C. In an embodiment, the edge of the display 220 may be formed to be substantially the same in shape as an adjacent outer edge of the front plate 202. In an embodiment (not illustrated), the interval between the outer edge of the display 220 and the outer edge of the front plate 202 may remain substantially even to give a larger area of visual exposure of the display 220.

In an embodiment (not shown), the screen display region of the display 220 may have a recess or opening in a portion thereof, and at least one or more of the audio module 214, sensor module 204, camera module 205, and light emitting device 206 may be aligned with the recess or opening. In an embodiment (not shown), at least one or more of the audio module 214, sensor module 204, camera module 205, fingerprint sensor (not shown), and light emitting device 206 may be included on the rear surface of the screen display area of the display 220. In an embodiment (not illustrated), the display 220 may be disposed to be coupled with, or adjacent, a touch detecting circuit, a pressure sensor capable of measuring the strength (pressure) of touches, and/or a digitizer for detecting a magnetic field-type stylus pen.

The audio modules 203, 207, and 214 may include a microphone hole 203 and speaker holes 207 and 214. A microphone for acquiring external sounds may be disposed in the microphone hole 203. In an embodiment, a plurality of microphones may be disposed to detect the direction of the sound. The speaker holes 207 and 214 may include an external speaker hole 207 and a phone receiver hole 214. In an embodiment, the speaker holes 207 and 214 and the microphone hole 203 may be implemented as a single hole, or speakers may be rested without the speaker holes 207 and 214 (e.g., piezo speakers).

The sensor modules 204 and 219 may generate an electrical signal or data value corresponding to an internal operating state or external environmental state of the electronic device 101. For example, the sensor modules 204 and 219 may include a first sensor module 204 (e.g., a proximity sensor) and/or a second sensor module (not shown) (e.g., a fingerprint sensor), which is disposed on the first surface 210A of the housing 210, and/or a third sensor module 219 and/or a fourth sensor module (e.g., a fingerprint sensor) disposed on the second surface 210B of the housing 210. The fingerprint sensor may be disposed on the second surface 210B or side surface 210C as well as the first surface 210A (e.g., the display 220) of the housing 210. The electronic device 101 may further include, e.g., at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 205, 212, and 213 may include a first camera device 205 disposed on the first surface 210A of the electronic device 101, and a second camera device 212 and/or a flash 213 disposed on the second surface 210B. The camera devices 205 and 212 may include one or more lenses, an image sensor, and/or an image signal processor. The flash 213 may include, e.g., a light emitting diode (LED) or a xenon lamp. In an embodiment, two or more lenses (an infrared (IR) camera, a wide-angle lens, and a telescopic lens) and image sensors may be disposed on one surface of the electronic device 101. In an embodiment, flash 213 may emit infrared light. The infrared light emitted by the flash 213 and reflected by the subject may be received through the third sensor module 219. The electronic device 101 or the processor of the electronic device 101 may detect depth information about the subject based on the time point when the infrared light is received from the third sensor module 219.

The key input device 217 may be disposed on the side surface 210C of the housing 210. In an embodiment, the electronic device 101 may exclude all or some of the above-mentioned key input devices 217 and the excluded key input devices 217 may be implemented in other forms, e.g., as soft keys, on the display 220. In an embodiment, the key input device may include the sensor module disposed on the second surface 210B of the housing 210.

The light emitting device 206 may be disposed on, e.g., the first surface 210A of the housing 210. The light emitting device 206 may provide, e.g., information about the state of the electronic device 101 in the form of light. In an embodiment, the light emitting device 206 may provide a light source that interacts with, e.g., the camera module 205. The light emitting device 206 may include, e.g., a light emitting diode (LED), an infrared (IR) LED, or a xenon lamp.

The connector holes 208 and 209 may include a first connector hole 208 for receiving a connector (e.g., a universal serial bus (USB) connector) for transmitting or receiving power and/or data to/from an external electronic device and/or a second connector hole 209 (e.g., an earphone jack) for receiving a connector for transmitting or receiving audio signals to/from the external electronic device.

FIG. 4 is a front exploded perspective view illustrating an electronic device according to an embodiment of the disclosure.

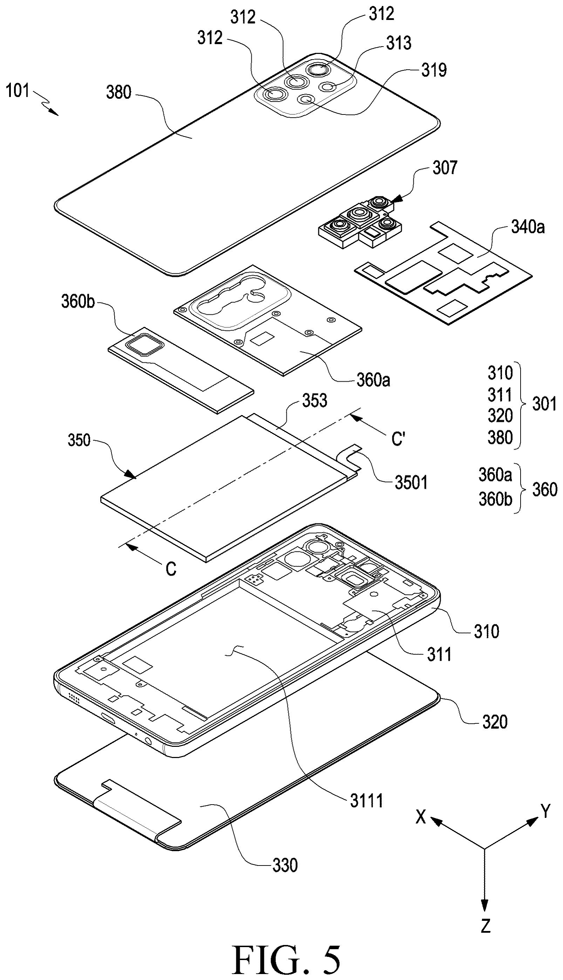

FIG. 5 is a rear exploded perspective view illustrating an electronic device according to an embodiment of the disclosure.

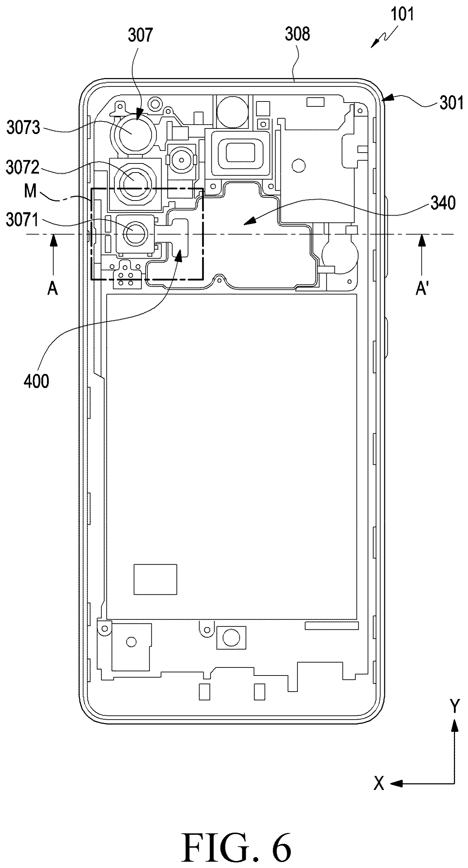

The embodiments of FIGS. 4 and 5 may be combined with the embodiments of FIGS. 1 to 3 or the embodiments of FIGS. 6 to 13C.

Referring to FIGS. 3 and 4, an electronic device 101 (e.g., the electronic device 101 of FIG. 1 or FIG. 2) may include a side structure 310, a first supporting member 311 (e.g., a bracket), a front plate 320 (e.g., the front plate 202 of FIG. 1), a display 330 (e.g., the display 220 of FIG. 1), at least one printed circuit board (or a board assembly) 340a or 340b, a battery 350, a second supporting member 360 (e.g., a rear case), an antenna, a camera assembly 307, and a rear plate 380 (e.g., the rear plate 211 of FIG. 2). When the plurality of printed circuit boards 340a and 340b are included, the electronic device 101 may include at least one flexible printed circuit board 340c to electrically connect different printed circuit boards. For example, the printed circuit boards 340a and 340b may include a first circuit board 340a disposed above the battery 350 (e.g., in the +Y-axis direction) and a second circuit board 340b disposed under the battery 350 (e.g., in the -Y-axis direction), and the flexible circuit board 340c may electrically connect the first circuit board 340a and the second circuit board 340b.

According to an embodiment, the electronic device 101 may exclude at least one (e.g., the first supporting member 311 or the second supporting member 360) of the components or may add other components. At least one of the components of the electronic device 101 may be the same or similar to at least one of the components of the electronic device 101 of FIG. 1 or 2 and no duplicate description is made below.

At least a portion of the first supporting member 311 may be provided in a flat plate shape. In an embodiment, the first supporting member 311 may be disposed inside the electronic device 101 to be connected with the side structure 310 or integrated with the side structure 310. The first supporting member 311 may be formed of, e.g., a metallic material and/or non-metallic material (e.g., polymer). When the first supporting member 311 is at least partially formed of a metallic material, a portion of the side structure 310 or the first supporting member 311 may function as an antenna. The display 330 may be joined onto one surface of the first supporting member 311, and the printed circuit boards 340a and 340b may be joined onto the opposite surface of the first supporting member 311. A processor, memory, and/or interface may be mounted on the printed circuit boards 340a and 340b. The processor may include one or more of, e.g., a central processing unit, an application processor, a graphic processing device, an image signal processing, a sensor hub processor, or a communication processor.

According to an embodiment, the housing 301 may include a first supporting member 311 and a side structure 310. According to an embodiment, the housing 301 may be understood as a structure for receiving, protecting, or disposing the printed circuit boards 340a and 340b or the battery 350. In an embodiment, the housing 301 may be understood as including a structure that the user may visually or tactfully recognize from the exterior of the electronic device 101, e.g., the side structure 310, the front plate 320, and/or the rear plate 380. For example, the housing 301 may include structures (e.g., the side structure 310, the front plate 320, and the rear plate 380) forming the appearance of the electronic device 101. The housing 301 may be identical to the housing 210 described in connection with FIGS. 2 and 3. In an embodiment, the 'front or rear surface of the housing 301' may refer to the first surface 210A of FIG. 1 or the second surface 210B of FIG. 2. In an embodiment, the first supporting member 311 may be disposed between the front plate 320 (e.g., the first surface 210A of FIG. 2) and the rear plate 380 (e.g., the second surface 210B of FIG. 3) and may function as a structure for placing an electrical/electronic component, such as the printed circuit boards 340a and 340b or the camera assembly 307.

The memory may include, e.g., a volatile or non-volatile memory.

The interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

The second supporting member 360 may include, e.g., an upper supporting member 360a or a lower supporting member 360b. In an embodiment, the upper supporting member 360a, together with a portion of the first supporting member 311, may be disposed to surround the printed circuit boards 340a and 340b (e.g., the first circuit board 340a). For example, the upper supporting member 360a of the second supporting member 360 may be disposed to face the first supporting member 311 with the first circuit board 340a interposed therebetween. In an embodiment, the lower supporting member 360b of the second supporting member 360 may be disposed to face the first supporting member 311 with the second circuit board 340b interposed therebetween. A circuit device (e.g., a processor, a communication module, or a memory) implemented in the form of an integrated circuit chip or various electrical/electronic components may be disposed on the printed circuit boards 340a and 340b. According to an embodiment, the printed circuit boards 340a and 340b may receive an electromagnetic shielding environment from the second supporting member 360. In an embodiment, the lower supporting member 360b may be utilized as a structure in which electrical/electronic components, such as a speaker module, or an interface (e.g., a USB connector, an SD card/MMC connector, or an audio connector) may be disposed. In an embodiment, electrical/electronic components, such as a speaker module, or an interface (e.g., a USB connector, an SD card/MMC connector, or an audio connector) may be disposed on an additional printed circuit board (not shown). For example, the lower supporting member 360b, together with the other part of the first supporting member 311, may be disposed to surround the additional printed circuit board (e.g., the second printed circuit board 340b). The speaker module or interface disposed on the additional printed circuit board (not shown) or the lower supporting member 360b may be disposed corresponding to the audio module 207 or connector holes 208 and 309 of FIG. 2.

The battery 350 may be a device for supplying power to at least one component of the electronic device 101. The battery 189 may include, e.g., a primary cell which is not rechargeable, a secondary cell which is rechargeable, or a fuel cell. At least a portion of the battery 350 may be disposed on substantially the same plane as the printed circuit boards 340a and 340b. The battery 350 may be integrally or detachably disposed inside the electronic device 101.

Although not shown, the antenna may include a conductor pattern implemented on the surface of the second supporting member 360 through, e.g., laser direct structuring. In an embodiment, the antenna may include a printed circuit pattern formed on the surface of the thin film. The thin film-type antenna may be disposed between the rear plate 380 and the battery 350. The antenna may include, e.g., a near-field communication (NFC) antenna, a wireless charging antenna, and/or a magnetic secure transmission (MST) antenna. The antenna may perform short-range communication with, e.g., an external device or may wirelessly transmit or receive power necessary for charging. In an embodiment of the present invention, another antenna structure may be formed by a portion or combination of the side structure 310 and/or the first supporting member 311.

According to an embodiment, the camera assembly 307 may include at least one camera module. Inside the electronic device 101, the camera assembly 307 (or at least one camera module) may receive at least a portion of the light incident through the optical hole or camera windows. In an embodiment, the camera assembly 307 may be disposed on the first supporting member 311 in a position adjacent to the printed circuit boards 340a and 340b. In an embodiment, the camera module(s) of the camera assembly 307 may be generally aligned with either one of the camera windows and be a least partially surrounded by the second supporting member 360 (e.g., the upper supporting member 360a).

According to an embodiment, the electronic device 101 may include camera holes 312, 313, and 319. A plurality of camera holes 312, 313, and 319 may be disposed to be spaced apart from each other. The camera assembly 307 may receive light passing through the camera holes 312, 313, and 319. The plurality of cameras (e.g., the cameras 3071, 3072, and 3073 of FIG. 6) may respectively correspond to the plurality of camera holes (e.g., the plurality of camera holes 312) spaced apart from each other.

According to an embodiment, the first supporting member 311 may include an accommodation portion 3111. The battery 350 may be disposed in the accommodation portion 3111. The battery 350 may include a terrace 353. The terrace 353 may protrude toward the circuit board (e.g., the circuit board 340 of FIG. 6). The battery 350 may include a battery connection member 3501 connecting the terrace 353 and the circuit board 340.

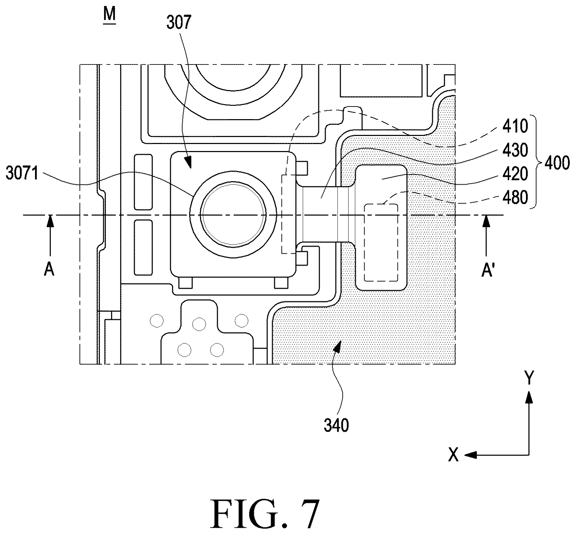

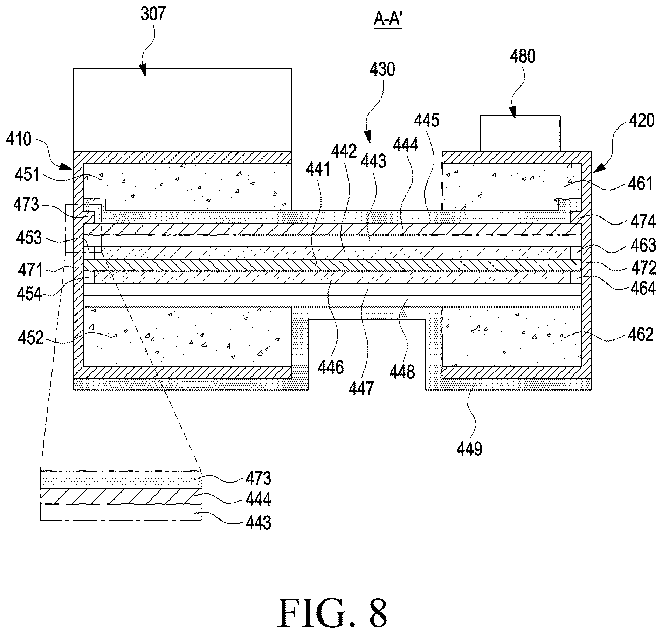

FIG. 6 is a view illustrating a state in which a rear plate (e.g., the rear plate 380 of FIGS. 4 and 5) is removed from the electronic device 101 of FIG. 3. FIG. 7 is an enlarged view of the partial area M of FIG. 6. The components described with reference to FIGS. 6 and 7 may be identical in whole or part to the components described with reference to FIGS. 1 to 5. Some or all of the components described with reference to FIGS. 6 and 7 may be the same as those described with reference to FIGS. 8 to 13C.

According to an embodiment, the electronic device 101 may include a housing 301, an antenna 308, and a circuit board 340. The housing 301 may be identical to the housing 301 described in connection with FIGS. 4 and 5. The description of the circuit boards 340a, 340b, and 340c made with reference to FIGS. 4 and 5 may be equally applied to the description of the circuit board 340. The antenna 308 may be coupled to the housing 301 and may be part of the housing 301. The antenna 308 may form a portion of the surface of the housing 301. The antenna 308 may be spaced apart from the camera assembly 307. Radio wave interference may occur between the antenna 308 and the camera assembly 307.

According to an embodiment, the electronic device 101 may include the camera assembly 307. The camera assembly 307 may captures a subject outside the rear plate (e.g., the rear plate 380 of FIG. 5). The camera assembly 307 may include a plurality of cameras 3071, 3072, and 3073. Each of the plurality of cameras 3071, 3072, and 3073 may be aligned in one direction (e.g., the Y direction).

According to an embodiment, the electronic device 101 may include a flexible circuit board 400. The flexible circuit board 400 may connect the camera assembly 307 with the circuit board 340. The flexible circuit board 400 may connect any one of the plurality of cameras 3071, 3072, and 3073 to the circuit board 340. The flexible circuit board 400 may extend from the circuit board 340 toward the camera assembly 307 in one direction (e.g., the X direction).

According to an embodiment, the flexible circuit board 400 may connect the first camera 3071 and the circuit board 340. At least a portion of the flexible circuit board 400 may be formed to be deformable. The flexible circuit board 400 may include a flexible material. The flexible circuit board 400 may include a rigid material.

According to an embodiment, the flexible circuit board 400 may include a first rigid portion 410. The flexible circuit board 400 may include a second rigid portion 420. The flexible circuit board 400 may include a flexible portion 430. The first rigid portion 410 may be connected to the camera assembly 307. The first rigid portion 410 may include a rigid material. The second rigid portion 420 may be connected to the circuit board 340. The second rigid portion 420 may include a rigid material. The flexible portion 430 may connect the first rigid portion 410 and the second rigid portion 420. The flexible portion 430 may include a flexible material.

According to an embodiment, the electronic device 101 may include a connector 480. The connector 480 may connect the flexible circuit board 400 and the circuit board 340. The connector 480 may connect the second rigid portion 420 and the circuit board 340.

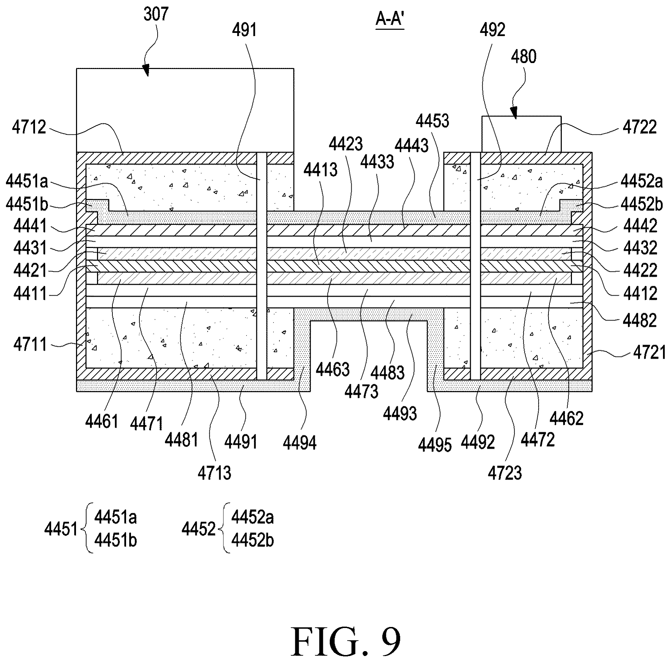

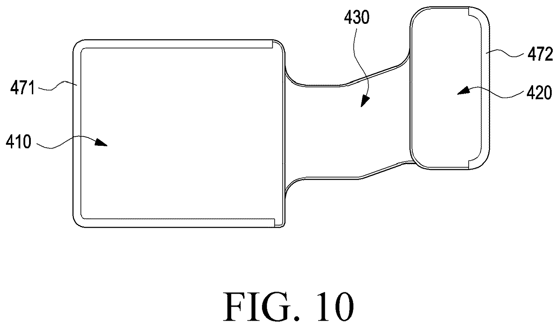

FIG. 8 is a cross-sectional view illustrating a flexible circuit board 400 connected to a camera assembly 307 and a connector 480 according to an embodiment of the disclosure. FIG. 9 is a cross-sectional view illustrating a flexible circuit board 400 connected to a camera assembly 307 and a connector 480 according to an embodiment of the disclosure. FIG. 8 is a cross-sectional view illustrating components (e.g., the camera assembly 307, the connector 480, and the flexible circuit board 400) taken along reference line A-A' illustrated in FIGS. 6 and 7, according to an embodiment. FIG. 9 is a cross-sectional view illustrating components (e.g., the camera assembly 307, the connector 480, and the flexible circuit board 400) taken along reference line A-A' illustrated in FIGS. 6 and 7, according to an embodiment. Some or all of the components described with reference to FIGS. 8 and 9 may be the same as those described with reference to FIGS. 1 to 7. Some or all of the components described with reference to FIGS. 8 and 9 may be the same as those described with reference to FIGS. 10 to 13C.

According to an embodiment, the flexible circuit board 400 may include a first rigid portion 410, a second rigid portion 420, and a flexible portion 430. The flexible portion 430 may be disposed between the first rigid portion 410 and the second rigid portion 420, and may connect the first rigid portion 410 and the second rigid portion 420. The flexible circuit board 400 may be integrally formed. The first rigid portion 410, the second rigid portion 420, and the flexible portion 430 may be integrally formed.

According to an embodiment, the flexible circuit board 400 may include a base layer 441. The base layer 441 may be disposed between the first conductive layer 442 and the second conductive layer 446. A portion of the base layer 441 may be disposed in the first rigid portion 410. A portion of the base layer 441 may be disposed in the second rigid portion 420. A portion of the base layer 441 may be disposed in the flexible portion 430.

According to an embodiment, the flexible circuit board 400 may include a first conductive layer 442. The first conductive layer 442 may include a copper (Cu) material. The first conductive layer 442 may be disposed between the base layer 441 and the first adhesive layer 443. A portion of the first conductive layer 442 may be disposed in the first rigid portion 410. A portion of the first conductive layer 442 may be disposed in the second rigid portion 420. A portion of the first conductive layer 442 may be disposed in the flexible portion 430.

According to an embodiment, the flexible circuit board 400 may include a first adhesive layer 443. The first adhesive layer 443 may be disposed between the first conductive layer 442 and the first cover layer 444. The first adhesive layer 443 may couple the first conductive layer 442 and the first cover layer 444. A portion of the first adhesive layer 443 may be disposed in the first rigid portion 410. A portion of the first adhesive layer 443 may be disposed in the second rigid portion 420. A portion of the first adhesive layer 443 may be disposed in the flexible portion 430.

According to an embodiment, the flexible circuit board 400 may include a first cover layer 444. The first cover layer 444 may be disposed between the first adhesive layer 443 and the first shielding layer 445. A portion of the first cover layer 444 may be disposed in the first rigid portion 410. A portion of the first cover layer 444 may be disposed in the second rigid portion 420. A portion of the first cover layer 444 may be disposed in the flexible portion 430.

According to an embodiment, the flexible circuit board 400 may include a first shielding layer 445. A portion of the first shielding layer 445 may be disposed in the first rigid portion 410. A portion of the first shielding layer 445 may be disposed in the second rigid portion 420. A portion of the first shielding layer 445 may be disposed in the flexible portion 430.

According to an embodiment, the flexible circuit board 400 may include a second conductive layer 446. The second conductive layer 446 may include a copper (Cu) material. The second conductive layer 446 may be disposed between the base layer 441 and the second adhesive layer 447. A portion of the second conductive layer 446 may be disposed in the first rigid portion 410. A portion of the second conductive layer 446 may be disposed in the second rigid portion 420. A portion of the second conductive layer 446 may be disposed in the flexible portion 430.

According to an embodiment, the flexible circuit board 400 may include a second adhesive layer 447. The second adhesive layer 447 may be disposed between the second conductive layer 446 and the second cover layer 448. The second adhesive layer 447 may couple the second conductive layer 446 and the second cover layer 448. A portion of the second adhesive layer 447 may be disposed in the first rigid portion 410. A portion of the second adhesive layer 447 may be disposed in the second rigid portion 420. A portion of the second adhesive layer 447 may be disposed in the flexible portion 430.

According to an embodiment, the flexible circuit board 400 may include a second cover layer 448. The second cover layer 448 may be disposed between the second adhesive layer 447 and the second shielding layer 449. A portion of the second cover layer 448 may be disposed in the first rigid portion 410. A portion of the second cover layer 448 may be disposed in the second rigid portion 420. A portion of the second cover layer 448 may be disposed in the flexible portion 430.

According to an embodiment, the flexible circuit board 400 may include a second shielding layer 449. A portion of the second shielding layer 449 may be disposed in the first rigid portion 410. A portion of the second shielding layer 449 may be disposed in the second rigid portion 420. A portion of the second shielding layer 449 may be disposed in the flexible portion 430.

According to an embodiment, the flexible circuit board 400 may include a first ground layer 471. The first ground layer 471 may be disposed in the first rigid portion 410. The first ground layer 471 may surround at least a portion of the first rigid portion 410. A portion of the first ground layer 471 may be disposed between the first rigid layer 451 and the camera assembly 307. A portion of the first ground layer 471 may cover an end portion of each of a plurality of layers (e.g., the base layer 441, the first conductive layer 442, the first adhesive layer 443, the first cover layer 444, the first shielding layer 445, the second conductive layer 446, the second adhesive layer 447, and the second cover layer 448). A portion of the first ground layer 471 may be disposed between the first rigid layer 452 and the second shielding layer 449. The cross section of the first ground layer 471 may be rectangular with one open side.

According to an embodiment, the flexible circuit board 400 may include a first ground protrusion 473. The first ground protrusion 473 may be connected to the first ground layer 471. The first ground protrusion 473 may protrude from the first ground layer 471 toward the first shielding layer 445. The first ground protrusion 473 may be disposed between the first shielding layer 445 and the first cover layer 444. The first ground protrusion 473 may provide a ground structure of the first shielding layer 445.

According to an embodiment, the flexible circuit board 400 may include first rigid layers 451 and 452. The first rigid layers 451 and 452 may include a rigid material. The first rigid layers 451 and 452 may include a 1-1th rigid layer 451 and a 1-2th rigid layer 452. A plurality of layers (e.g., the base layer 441, the first conductive layer 442, the first adhesive layer 443, the first cover layer 444, the first shielding layer 445, the second conductive layer 446, the second adhesive layer 447, and the second cover layer 448) may be disposed between the 1-1th rigid layer 451 and the 1-2th rigid layer 452. The 1-1th rigid layer 451 may be disposed between the first ground layer 471 and the first shielding layer 445. The 1-2th rigid layer 452 may be disposed between the first ground layer 471 and the second cover layer 448.

According to an embodiment, the flexible circuit board 400 may include first rigid bodies 453 and 454. The first rigid bodies 453 and 454 may include a 1-1th rigid body 453 and a 1-2th rigid body 454. The 1-1th rigid body 453 may be disposed between the first ground layer 471 and the first conductive layer 442. The 1-1th rigid body 453 may be disposed between the base layer 441 and the first adhesive layer 443. The 1-2th rigid body 454 may be disposed between the first ground layer 471 and the second conductive layer 446. The 1-2th rigid body 454 may be disposed between the base layer 441 and the second adhesive layer 447.

According to an embodiment, the flexible circuit board 400 may include a second ground layer 472. The second ground layer 472 may be disposed in the second rigid portion 420. The second ground layer 472 may surround at least a portion of the second rigid portion 420. A portion of the second ground layer 472 may be disposed between the second rigid layer 461 and the connector 480. A portion of the second ground layer 472 may cover an end portion of each of a plurality of layers (e.g., the base layer 441, the first conductive layer 442, the first adhesive layer 443, the first cover layer 444, the first shielding layer 445, the second conductive layer 446, the second adhesive layer 447, and the second cover layer 448). A portion of the second ground layer 472 may be disposed between the second rigid layer 462 and the second shielding layer 449. The cross section of the second ground layer 472 may be rectangular with one open side.

According to an embodiment, the flexible circuit board 400 may include a second ground protrusion 474. The second ground protrusion 474 may be connected to the second ground layer 472. The second ground protrusion 474 may protrude from the second ground layer 472 toward the first shielding layer 445. The second ground protrusion 474 may be disposed between the first shielding layer 445 and the first cover layer 444. The second ground protrusion 474 may provide a ground structure of the first shielding layer 445.

According to an embodiment, the flexible circuit board 400 may include second rigid layers 461 and 462. The second rigid layers 461 and 462 may include a rigid material. The second rigid layers 461 and 462 may include a 2-1th rigid layer 461 and a 2-2th rigid layer 462. A plurality of layers (e.g., the base layer 441, the first conductive layer 442, the first adhesive layer 443, the first cover layer 444, the first shielding layer 445, the second conductive layer 446, the second adhesive layer 447, and the second cover layer 448) may be disposed between the 2-1th rigid layer 461 and the 2-2th rigid layer 462. The 2-1th rigid layer 461 may be disposed between the second ground layer 472 and the first shielding layer 445. The 2-2th rigid layer 462 may be disposed between the second ground layer 472 and the second cover layer 448.

According to an embodiment, the flexible circuit board 400 may include second rigid bodies 463 and 464. The second rigid bodies 463 and 464 may include a 2-1th rigid body 463 and a 2-2th rigid body 464. The 2-1th rigid body 463 may be disposed between the second ground layer 472 and the first conductive layer 442. The 2-1th rigid body 463 may be disposed between the base layer 441 and the first adhesive layer 443. The 2-2th rigid body 464 may be disposed between the second ground layer 472 and the second conductive layer 446. The 2-2th rigid body 464 may be disposed between the base layer 441 and the second adhesive layer 447.

According to an embodiment, the base layer 441 may include a first base layer portion 4411, a second base layer portion 4412, and a third base layer portion 4413. The first, second, and third base layer portions 4411, 4412, and 4413 may be integral. The first base layer portion 4411 may be disposed in the first rigid portion 410. The second base layer portion 4412 may be disposed in the second rigid portion 420. The third base layer portion 4413 may be disposed in the flexible portion 430. The first base layer portion 4411 may be disposed between the 1-1th conductive portion 4421 and the 2-1th conductive portion 4461. The second base layer portion 4412 may be disposed between the 1-2th conductive portion 4422 and the 2-2th conductive portion 4462. The third base layer portion 4413 may be disposed between the 1-3th conductive portion 4423 and the 2-3th conductive portion 4463.

According to an embodiment, the first conductive layer 442 may include a 1-1th conductive portion 4421, a 1-2th conductive portion 4422, and a 1-3th conductive portion 4423. The 1-1th, 1-2th, and 1-3th conductive portions 4421, 4422, and 4423 may be integral. The 1-1th conductive portion 4421 may be disposed in the first rigid portion 410. The 1-2th conductive portion 4422 may be disposed in the second rigid portion 420. The 1-3th conductive portion 4423 may be disposed in the flexible portion 430. The 1-1th conductive portion 4421 may be disposed between the first base layer portion 4411 and the 1-1th adhesive layer portion 4431. The 1-2th conductive portion 4422 may be disposed between the second base layer portion 4412 and the 1-2th adhesive layer portion 4432. The 1-3th conductive portion 4423 may be disposed between the third base layer portion 4413 and the 1-3th adhesive layer portion 4433.

According to an embodiment, the first adhesive layer 443 may include a 1-1th adhesive layer portion 4431, a 1-2th adhesive layer portion 4432, and a 1-3th adhesive layer portion 4433. The 1-1th, 1-2th, and 1-3th adhesive layer portions 4431, 4432, and 4433 may be integral. The 1-1th adhesive layer portion 4431 may be disposed in the first rigid portion 410. The 1-2th adhesive layer portion 4432 may be disposed in the second rigid portion 420. The 1-3th adhesive layer portion 4433 may be disposed in the flexible portion 430. The 1-1th adhesive layer portion 4431 may be disposed between the 1-1th conductive portion 4421 and the 1-1th cover layer portion 4441. The 1-2th adhesive layer portion 4432 may be disposed between the 1-2th conductive portion 4422 and the 1-2th cover layer portion 4442. The 1-3th adhesive layer portion 4433 may be disposed between the 1-3th conductive portion 4423 and the 1-3th cover layer portion 4443.

According to an embodiment, the first cover layer 444 may include a 1-1th cover layer portion 4441, a 1-2th cover layer portion 4442, and a 1-3th cover layer portion 4443. The 1-1th, 1-2th, and 1-3th cover layer portions 4441, 4442, and 4443 may be integral. The 1-1th cover layer portion 4441 may be disposed in the first rigid portion 410. The 1-2th cover layer portion 4442 may be disposed in the second rigid portion 420. The 1-3th cover layer portion 4443 may be disposed in the flexible portion 430. The 1-1th cover layer portion 4441 may be disposed between the 1-1th adhesive layer portion 4431 and the 1-1th shielding layer portion 4451. The 1-2th cover layer portion 4442 may be disposed between the 1-2th adhesive layer portion 4432 and the 1-2th shielding layer portion 4452. The 1-3th cover layer portion 4443 may be disposed between the 1-3th adhesive layer portion 4433 and the 1-3th shielding layer portion 4453.

According to an embodiment, the first shielding layer 445 may include a 1-1th shielding layer portion 4451, a 1-2th shielding layer portion 4452, and a 1-3th shielding layer portion 4453. The 1-1th, 1-2th, and 1-3th shielding layer portions 4451, 4452, and 4453 may be integral. The 1-1th shielding layer portion 4451 may be disposed in the first rigid portion 410. The 1-2th shielding layer portion 4452 may be disposed in the second rigid portion 420. The 1-3th shielding layer portion 4453 may be disposed in the flexible portion 430. The 1-1th shielding layer portion 4451 may be disposed between the 1-1th cover layer portion 4441 and the 1-1th rigid layer 451. The 1-2th shielding layer portion 4452 may be disposed between the 1-2th cover layer portion 4442 and the 2-1th rigid layer 461. The 1-1th shielding layer portion 4451 may include an extending portion 4451a and a bending portion 4451b. The extending portion 4451a may be disposed between the first rigid layer 451 and the first cover layer 444. The bending portion 4451b may be bent from the extending portion 4451a. The bending portion 4451b may surround at least a portion of the first ground protrusion 473. The bending portion 4451b may be connected to the first ground layer 471. The first ground protrusion 473 may be disposed between the bending portion 4451b and the first cover layer 444. The first ground protrusion 473 may be disposed between the extending portion 4451a and the first ground layer 471. The 1-2th shielding layer portion 4452 may include an extending portion 4452a and a bending portion 4452b. The extending portion 4452a may be disposed between the second rigid layer 461 and the first cover layer 444. The bending portion 4452b may be bent from the extending portion 4452a. The bending portion 4452b may surround at least a portion of the second ground protrusion 474. The bending portion 4452b may be connected to the second ground layer 472. The second ground protrusion 474 may be disposed between the bending portion 4452b and the first cover layer 444. The second ground protrusion 474 may be disposed between the extending portion 4452a and the second ground layer 472.

According to an embodiment, the second conductive layer 446 may include a 2-1th conductive portion 4461, a 2-2th conductive portion 4462, and a 2-3th conductive portion 4463. The 2-1th, 2-2th, and 2-3th conductive portions 4461, 4462, and 4463 may be integral. The 2-1th conductive portion 4461 may be disposed in the first rigid portion 410. The 2-2th conductive portion 4462 may be disposed in the second rigid portion 420. The 2-3th conductive portion 4463 may be disposed in the flexible portion 430. The 2-1th conductive portion 4461 may be disposed between the first base layer portion 4411 and the 2-1th adhesive layer portion 4471. The 2-2th conductive portion 4462 may be disposed between the second base layer portion 4412 and the 2-2th adhesive layer portion 4472. The 2-3th conductive portion 4463 may be disposed between the third base layer portion 4413 and the 2-3th adhesive layer portion 4473.

According to an embodiment, the second adhesive layer 447 may include a 2-1th adhesive layer portion 4471, a 2-2th adhesive layer portion 4472 and a 2-3th adhesive layer portion 4473. The 2-1th, 2-2th, and 2-3th adhesive layer portions 4471, 4472, and 4473 may be integral. The 2-1th adhesive layer portion 4471 may be disposed in the first rigid portion 410. The 2-2th adhesive layer portion 4472 may be disposed in the second rigid portion 420. The 2-3th adhesive layer portion 4473 may be disposed in the flexible portion 430. The 2-1th adhesive layer portion 4471 may be disposed between the 2-1th conductive portion 4461 and the 2-1th cover layer portion 4481. The 2-2th adhesive layer portion 4472 may be disposed between the 2-2th conductive portion 4462 and the 2-2th cover layer portion 4482. The 2-3th adhesive layer portion 4473 may be disposed between the 2-3th conductive portion 4463 and the 2-3th cover layer portion 4483.

According to an embodiment, the second cover layer 448 may include a 2-1th cover layer portion 4481, a 2-2th cover layer portion 4482, and a 2-3th cover layer portion 4483. The 2-1th, 2-2th, and 2-3th cover layer portions 4481, 4482, and 4483 may be integral. The 2-1th cover layer portion 4481 may be disposed in the first rigid portion 410. The 2-2th cover layer portion 4482 may be disposed in the second rigid portion 420. The 2-3th cover layer portion 4483 may be disposed in the flexible portion 430. The 2-1th cover layer portion 4481 may be disposed between the 2-1th adhesive layer portion 4471 and the 2-1th shielding layer portion 4411. The 2-2th cover layer portion 4482 may be disposed between the 2-2th adhesive layer portion 4472 and the 2-2th shielding layer portion 4492. The 2-3th cover layer portion 4483 may be disposed between the 2-3th adhesive layer portion 4473 and the 2-3th shielding layer portion 4493.

According to an embodiment, the second shielding layer 449 may include a 2-1th shielding layer portion 4491, a 2-2th shielding layer portion 4492, and a 2-3th shielding layer portion 4493. The 2-1th, 2-2th, and 2-3th shielding layer portions 4491, 4492, and 4493 may be integral. The 2-1th shielding layer portion 4491 may be disposed in the first rigid portion 410. The 2-2th shielding layer portion 4492 may be disposed in the second rigid portion 420. The 2-3th shielding layer portion 4493 may be disposed in the flexible portion 430. The second shielding layer 449 may include a first connecting portion 4494 and a second connecting portion 4495. The first connecting portion 4494 may connect the 2-1th shielding layer portion 4491 and the 2-3th shielding layer portion 4493. The second connecting portion 4495 may connect the 2-2th shielding layer portion 4492 and the 2-3th shielding layer portion 4493.

According to an embodiment, the first ground layer 471 may include a first side portion 4711, a first device coupling portion 4712, and a first shield layer coupling portion 4713. The first side portion 4711, the first device coupling portion 4712, and the first shielding layer coupling portion 4713 may be integrally formed. The first side portion 4711 may cover an end portion of each of a plurality of layers (e.g., the base layer 441, the first conductive layer 442, the first adhesive layer 443, the first cover layer 444, the first shielding layer 445, the second conductive layer 446, the second adhesive layer 447, and the second cover layer 448). The first shielding layer 445 may be connected to the first side portion 4711. The first ground protrusion 473 may protrude from the first side portion 4711 toward the first shielding layer 445. The first rigid bodies 453 and 454 may be disposed between the conductive layers 442 and 446 and the first side portion 4711. The first device coupling portion 4712 may be disposed between the camera assembly 307 and the 1-1th rigid layer 451. The first shielding layer coupling portion 4713 may be disposed between the 1-2th rigid layer 452 and the 2-1th shielding layer portion 4491.

According to an embodiment, the second ground layer 472 may include a second side portion 4721, a second device coupling portion 4722, and a second shield layer coupling portion 4723. The second side portion 4721, the second device coupling portion 4722, and the second shielding layer coupling portion 4723 may be integrally formed. The second side portion 4721 may cover an end portion of each of a plurality of layers (e.g., the base layer 441, the first conductive layer 442, the first adhesive layer 443, the first cover layer 444, the first shielding layer 445, the second conductive layer 446, the second adhesive layer 447, and the second cover layer 448). The first shielding layer 445 may be connected to the second side portion 4721. The second ground protrusion 474 may protrude from the second side portion 4721 toward the first shielding layer 445. The second rigid bodies 463 and 464 may be disposed between the conductive layers 442 and 446 and the second side portion 4721. The second device coupling portion 4722 may be disposed between the connector 480 and the 2-1th rigid layer 461. The second shielding layer coupling portion 4723 may be disposed between the 2-2th rigid layer 462 and the 2-2th shielding layer portion 4492.

According to an embodiment, the flexible circuit board 400 may include a first conductive via 491 and a second conductive via 492. The first conductive via 491 may be disposed in the first rigid portion 410. The first conductive via 491 may be disposed in a boundary portion between the first rigid portion 410 and the flexible portion 430. The second conductive via 492 may be disposed in the second rigid portion 420. The second conductive via 492 may be disposed in a boundary portion between the second rigid portion 420 and the flexible portion 430. The first conductive via 491 may extend through a plurality of layers (e.g., the base layer 441, the first conductive layer 442, the first adhesive layer 443, the first cover layer 444, the first shielding layer 445, the second conductive layer 446, the second adhesive layer 447, the second cover layer 448, the first rigid layers 451 and 452, and the first ground layer 471). The first conductive via 491 may extend between the first device coupling portion 4712 and the first shielding layer coupling portion 4713. The first conductive via 491 may be connected to the camera assembly 307 through the first ground layer 471. The first conductive via 491 may be connected to the second shielding layer 449 through the first ground layer 471. The second conductive via 492 may extend through a plurality of layers (e.g., the base layer 441, the first conductive layer 442, the first adhesive layer 443, the first cover layer 444, the first shielding layer 445, the second conductive layer 446, the second adhesive layer 447, the second cover layer 448, the second rigid layers 461 and 462, and the second ground layer 472). The second conductive via 492 may extend between the second device coupling portion 4722 and the second shielding layer coupling portion 4723. The second conductive via 492 may be connected to the second shielding layer 449 through the second ground layer 472.

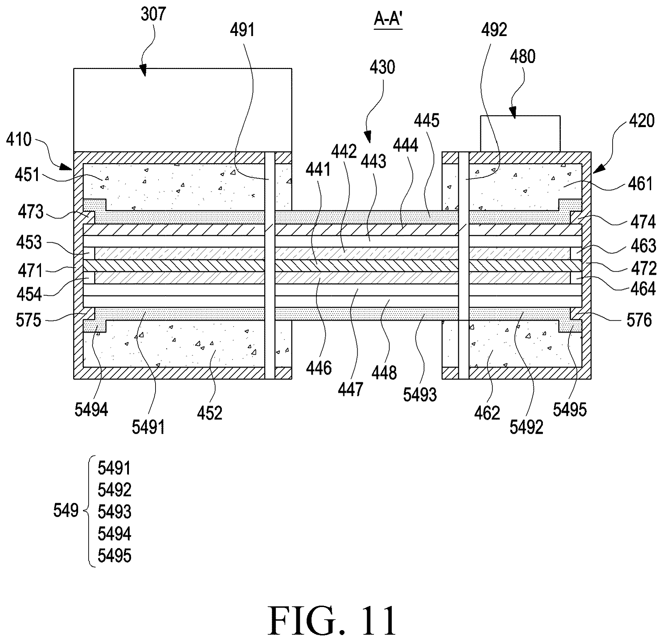

FIG. 10 is a view conceptually illustrating a structure of a flexible circuit board 400. Some or all of the components described with reference to FIG. 10 may be the same as those described with reference to FIGS. 1 to 9. Some or all of the components described with reference to FIG. 10 may be the same as those described with reference to FIGS. 11 to 13C.

According to an embodiment, the flexible portion 430 may connect the first rigid portion 410 and the second rigid portion 420.

According to an embodiment, the first ground layer 471 may surround at least a portion of the first rigid portion 410. The second ground layer 472 may surround at least a portion of the second rigid portion 420.

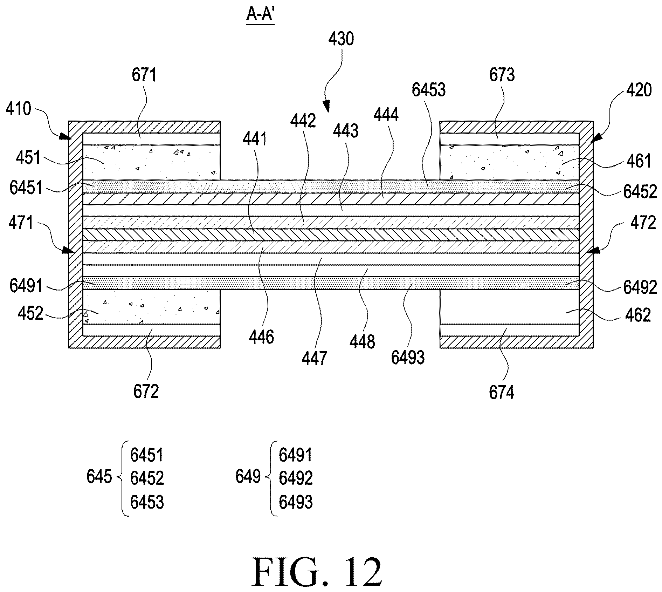

FIG. 11 is a cross-sectional view illustrating a state in which a flexible circuit board 400 is connected to a camera assembly 307 and a connector 480 according to an embodiment of the disclosure. Some or all of the components described with reference to FIG. 11 may be the same as those described with reference to FIGS. 1 to 10. Some or all of the components described with reference to FIG. 11 may be the same as those described with reference to FIGS. 12 to 13C.

According to an embodiment, the flexible circuit board 400 may include a base layer 441, a first conductive layer 442, a first adhesive layer 443, a first cover layer 444, a first shielding layer 445, a second conductive layer 446, a second adhesive layer 447, a second cover layer 448, first rigid layers 451 and 452, second rigid layers 461 and 462, a first ground layer 471, a second ground layer 472, a first conductive via 491, and a second conductive via 492. The description made with reference to FIGS. 8 and 9 may be equally applied to the description of the above-described components (e.g., the base layer 441, the first conductive layer 442, the first adhesive layer 443, the first cover layer 444, the first shielding layer 445, the second conductive layer 446, the second adhesive layer 447, the second cover layer 448, the first rigid layers 451 and 452, the second rigid layers 461 and 462, the first ground layer 471, the second ground layer 472, the first conductive via 491, and the second conductive via 492).

According to an embodiment, the flexible circuit board 400 may include a second shielding layer 549. A portion of the second shielding layer 549 may be disposed in the first rigid portion 410. A portion of the second shielding layer 549 may be disposed in the second rigid portion 420. A portion of the second shielding layer 549 may be disposed in the flexible portion 430.

According to an embodiment, the second shielding layer 549 may include a first shielding layer portion 5491, a second shielding layer portion 5492, and a third shielding layer portion 5493. The first shielding layer portion 5491 may be disposed between the second cover layer 448 and the 1-2th rigid layer 452. The second shielding layer portion 5492 may be disposed between the second cover layer 448 and the 2-2th rigid layer 462.

According to an embodiment, the second shielding layer 549 may include a first shielding layer bending portion 5494 and a second shielding layer bending portion 5495. The first shielding layer bending portion 5494 may be bent from the first shielding layer portion 5491. The first shielding layer bending portion 5494 may be connected to the first ground layer 471. The second shielding layer bending portion 5495 may be bent from the second shielding layer portion 5492. The second shielding layer bending portion 5495 may be connected to the second ground layer 472.

According to an embodiment, the flexible circuit board 400 may include a third ground protrusion 575 and a fourth ground protrusion 576. The third ground protrusion 575 may be disposed between the first ground layer 471 and the first shielding layer portion 5491. The third ground protrusion 575 may be disposed between the second cover layer 448 and the first shielding layer bending portion 5494. The fourth ground protrusion 576 may be disposed between the second ground layer 472 and the second shielding layer portion 5492. The fourth ground protrusion 576 may be disposed between the second cover layer 448 and the second shielding layer bending portion 5495.

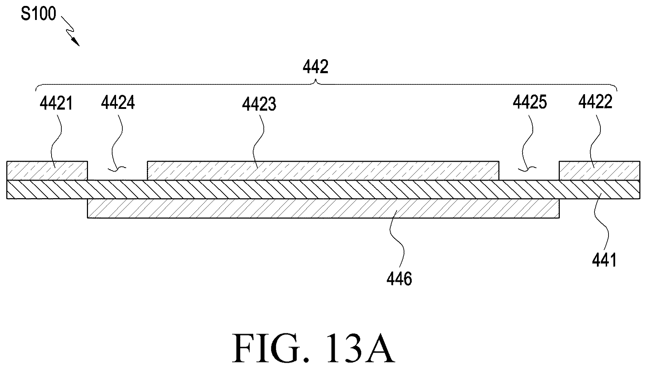

FIG. 12 is a cross-sectional view illustrating a flexible circuit board 400 according to an embodiment of the disclosure. Some or all of the components described with reference to FIG. 12 may be the same as those described with reference to FIGS. 1 to 11. Some or all of the components described with reference to FIG. 12 may be the same as those described with reference to FIGS. 13A to 13C.

According to an embodiment, the flexible circuit board 400 may include a base layer 441, a first conductive layer 442, a first adhesive layer 443, a first cover layer 444, a second conductive layer 446, a second adhesive layer 447, a second cover layer 448, first rigid layers 451 and 452, second rigid layers 461 and 462, a first ground layer 471, and a second ground layer 472. The description made with reference to FIGS. 8 and 9 may be equally applied to the description of the above-described components (e.g., the base layer 441, the first conductive layer 442, the first adhesive layer 443, the first cover layer 444, the second conductive layer 446, the second adhesive layer 447, the second cover layer 448, the first rigid layers 451 and 452, the second rigid layers 461 and 462, the first ground layer 471, and the second ground layer 472).

According to an embodiment, the flexible circuit board 400 may include a first shielding layer 645. The first shielding layer 645 may include a 1-1th shielding layer portion 6451 disposed in the first rigid portion 410. The first shielding layer 645 may include a 1-2th shielding layer portion 6452 disposed in the second rigid portion 420. The first shielding layer 645 may include a 1-3th shielding layer portion 6453 disposed in the flexible portion 430. The 1-1th shielding layer portion 6451 may be connected to the first ground layer 471. The 1-1th shielding layer portion 6451 may be disposed between the first rigid layer 451 and the first cover layer 444. The 1-2th shielding layer portion 6452 may be connected to the second ground layer 472. The 1-2th shielding layer portion 6452 may be disposed between the second rigid layer 461 and the first cover layer 444.

According to an embodiment, the flexible circuit board 400 may include a second shielding layer 649. The second shielding layer 649 may include a 2-1th shielding layer portion 6491 disposed in the first rigid portion 410. The second shielding layer 649 may include a 2-2th shielding layer portion 6492 disposed in the second rigid portion 420. The second shielding layer 649 may include a 2-3th shielding layer portion 6493 disposed in the flexible portion 430. The 2-1th shielding layer portion 6491 may be connected to the first ground layer 471. The 2-1th shielding layer portion 6491 may be disposed between the first rigid layer 452 and the second cover layer 448. The 2-2th shielding layer portion 6492 may be connected to the second ground layer 472. The 2-2th shielding layer portion 6492 may be disposed between the second rigid layer 462 and the second cover layer 448.

According to an embodiment, the flexible circuit board 400 may include first reinforcing layers 671 and 672. The first reinforcing layers 671 and 672 may be disposed between the first rigid layers 451 and 452 and the first ground layer 471. The first reinforcing layers 671 and 672 may include a 1-1th reinforcing layer 671 disposed between the 1-1th rigid layer 451 and the first ground layer 471. The first reinforcing layers 671 and 672 may include a 1-2th reinforcing layer 672 disposed between the 1-2th rigid layer 452 and the first ground layer 471.

According to an embodiment, the flexible circuit board 400 may include second reinforcing layers 673 and 674. The second reinforcing layers 673 and 674 may be disposed between the second rigid layers 461 and 462 and the second ground layer 472. The second reinforcing layers 673 and 674 may include a 2-1th reinforcing layer 673 disposed between the 2-1th rigid layer 461 and the second ground layer 472. The second reinforcing layers 673 and 674 may include a 2-2th reinforcing layer 674 disposed between the 2-2th rigid layer 462 and the second ground layer 472.

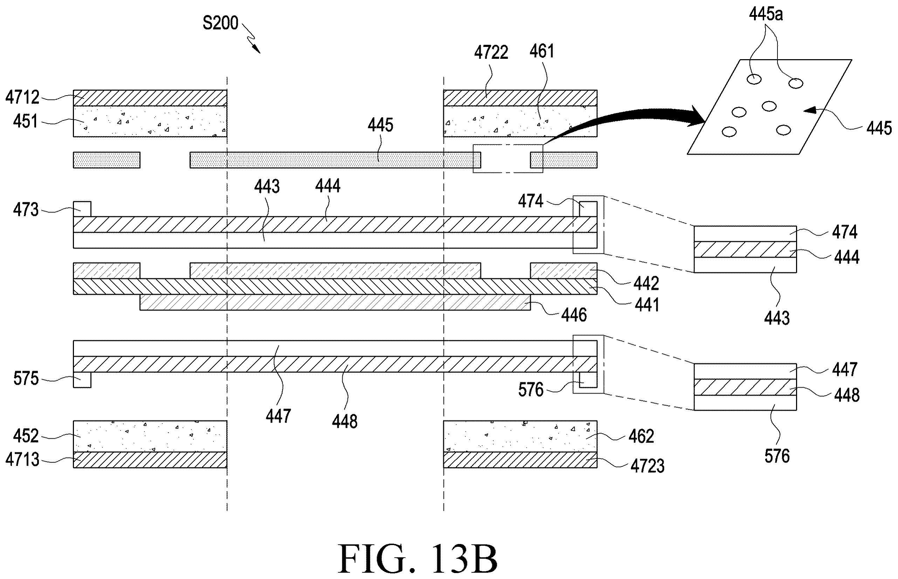

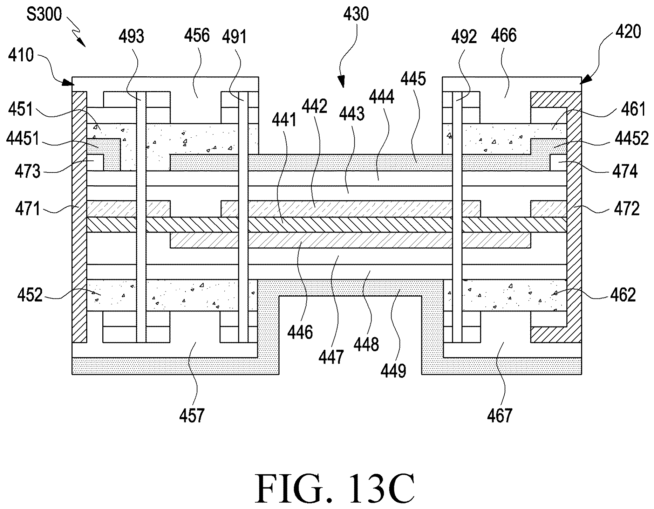

FIGS. 13A, 13B, and 13C are views illustrating a method for manufacturing a flexible circuit board 400 according to an embodiment of the disclosure. Some or all of the components described with reference to FIGS. 13A to 13C may be the same as those described with reference to FIGS. 1 to 12.

According to an embodiment, the method for manufacturing the flexible circuit board 400 may include a first process S100, a second process S200, and a third process S300. As illustrated in FIG. 13A, the first process S100 may be an operation of disposing the base layer 441 and the conductive layers 442 and 446. As illustrated in FIG. 13B, the second process S200 may be an operation of stacking a plurality of layers. As illustrated in FIG. 13C, the third process S300 may be an operation of completing the flexible circuit board 400.

Referring to FIG. 13A, the first conductive layer 442 and the second conductive layer 446 may be coupled to the base layer 441. The first conductive layer 442 may be coupled to a first surface of the base layer 441, and the second conductive layer 446 may be coupled to a second surface opposite to the first surface of the base layer 441. The first conductive layer 442 may include a plurality of holes 4424 and 4425, and a plurality of portions 4421, 4422, and 4423 spaced apart from each other with respect to the plurality of holes 4424 and 4425.

Referring to FIG. 13B, other layers (e.g., the first adhesive layer 443, the first cover layer 444, the first shielding layer 445, the second adhesive layer 447, the second cover layer 448, the first rigid layers 451 and 452, the second rigid layers 461 and 462, the first ground layers 4712 and 4713, the second ground layers 4722 and 4723, and the ground protrusions 473, 575, 474, and 576) may be stacked on the assembly 441, 442, and 446 of FIG. 13A. The first shielding layer 445 may include a plurality of through holes 445a.

Referring to FIG. 13C, after assembly as illustrated in FIG. 13B, the second shielding layer 449, the first ground layer 471, the second ground layer 472, the conductive vias 491, 492, and 493, and the reinforcements 456, 457, 466, and 467 may be assembled.

An electronic device includes a housing, a circuit board disposed in the housing, a camera assembly connected to the circuit board, and an antenna. An electronic device includes a flexible circuit board connecting a camera assembly and a circuit board. The camera assembly and the antenna are spaced apart from each other, and radio wave interference between the component of the camera assembly and the antenna may occur. The flexible circuit board may include a shielding layer for reducing radio wave interference. Due to the structure of the shielding layer, a step may be formed at a portion where the flexible circuit board and the camera assembly or connector are connected. Due to the structure of the shielding layer, the shielding layer may not be properly grounded.

An object of the disclosure may be to reduce radio wave interference between the antenna and the camera assembly.

An object of the disclosure may be to facilitate grounding of a flexible circuit board.

Objects of the disclosure are not limited to the mentioned objects, and may be determined various without departing from the spirit and scope of the disclosure.

An electronic device according to various embodiments of the disclosure may reduce radio wave interference between an antenna and a camera assembly by disposing a shielding layer on a flexible circuit board.

An electronic device according to various embodiments of the disclosure may facilitate grounding of a flexible circuit board by connecting a shielding layer and a ground layer.

Effects obtainable from the disclosure are not limited to the above-mentioned effects, and other effects not mentioned may be clearly understood by those skilled in the art from the following description.

An electronic device (e.g., 101 of FIGS. 1 to 13C) according to an embodiment of the disclosure may include a housing (e.g., 301 of FIGS. 1 to 13C).

The electronic device (e.g., 101 of FIGS. 1 to 13C) according to an embodiment of the disclosure may include a circuit board (e.g., 340 of FIGS. 1 to 13C) disposed in the housing (e.g., 301 of FIGS. 1 to 13C).

The electronic device (e.g., 101 of FIGS. 1 to 13C) according to an embodiment of the disclosure may include a camera assembly (e.g., 307 of FIGS. 1 to 13C) spaced apart from the circuit board (e.g., 340 of FIGS. 1 to 13C).

The electronic device (e.g., 101 of FIGS. 1 to 13C) according to an embodiment of the disclosure may include a flexible circuit board (e.g., 400 of FIGS. 1 to 13C) including a first rigid portion (e.g., 410 of FIGS. 1 to 13C) connected to the camera assembly (e.g., 307 of FIGS. 1 to 13C), a second rigid portion (e.g., 420 of FIGS. 1 to 13C) connected to the circuit board (e.g., 340 of FIGS. 1 to 13C), and a flexible portion (e.g., 430 of FIGS. 1 to 13C) connecting the first rigid portion (e.g., 410 of FIGS. 1 to 13C) and the second rigid portion (e.g., 420 of FIGS. 1 to 13C).

The flexible circuit board (e.g., 400 of FIGS. 1 to 13C) according to an embodiment of the disclosure may include a base layer (e.g., 441 of FIGS. 1 to 13C).

The flexible circuit board (e.g., 400 of FIGS. 1 to 13C) according to an embodiment of the disclosure may include a first conductive layer (e.g., 442 of FIGS. 1 to 13C) coupled to the base layer (e.g., 441 of FIGS. 1 to 13C).

The flexible circuit board (e.g., 400 of FIGS. 1 to 13C) according to an embodiment of the disclosure may include a first shielding layer (e.g., 445 of FIGS. 1 to 13C) including a 1-1th shield layer portion (e.g., 4451 of FIGS. 1 to 13C) located in the first rigid portion (e.g., 410 of FIGS. 1 to 13C), a 1-2th shield layer portion (e.g., 4452 of FIGS. 1 to 13C) located in the second rigid portion (e.g., 420 of FIGS. 1 to 13C), and a 1-3th shield layer portion (e.g., 4453 of FIGS. 1 to 13C) located in the flexible portion (e.g., 430 of FIGS. 1 to 13C), and spaced apart from the first conductive layer (e.g., 442 of FIGS. 1 to 13C).

The flexible circuit board (e.g., 400 of FIGS. 1 to 13C) according to an embodiment of the disclosure may include a first ground layer (e.g., 471 of FIGS. 1 to 13C) at least partially extending along a circumference of the first rigid portion (e.g., 410 of FIGS. 1 to 13C) and connected to the first shielding layer (e.g., 445 of FIGS. 1 to 13C).

The flexible circuit board (e.g., 400 of FIGS. 1 to 13C) according to an embodiment of the disclosure may include a first ground protrusion (e.g., 473 of FIGS. 1 to 13C) protruding from the first ground layer (e.g., 471 of FIGS. 1 to 13C) and disposed between the first ground layer (e.g., 471 of FIGS. 1 to 13C) and the first shielding layer (e.g., 445 of FIGS. 1 to 13C).

The first shielding layer (e.g., 445 of FIGS. 1 to 13C) according to an embodiment of the disclosure may include an extending portion (e.g., 4451a of FIGS. 1 to 13C) spaced apart from the first ground layer (e.g., 471 of FIGS. 1 to 13C).

The first shielding layer (e.g., 445 of FIGS. 1 to 13C) according to an embodiment of the disclosure may include a bending portion (e.g., 4451b of FIGS. 1 to 13C) connecting the extending portion (e.g., 4451a of FIGS. 1 to 13C) and the first ground layer (e.g., 471 of FIGS. 1 to 13C) and surrounding at least a portion of the first ground protrusion (e.g., 473 of FIGS. 1 to 13C).

The flexible circuit board (e.g., 400 of FIGS. 1 to 13C) according to an embodiment of the disclosure may include a second ground layer (e.g., 472 of FIGS. 1 to 13C) at least partially extending along a circumference of the second rigid portion (e.g., 420 of FIGS. 1 to 13C) and connected to the first shielding layer (e.g., 445 of FIGS. 1 to 13C).

The flexible circuit board (e.g., 400 of FIGS. 1 to 13C) according to an embodiment of the disclosure may include a second ground protrusion (e.g., 474 of FIGS. 1 to 13C) protruding from the second ground layer (e.g., 472 of FIGS. 1 to 13C) and disposed between the second ground layer (e.g., 472 of FIGS. 1 to 13C) and the first shielding layer (e.g., 445 of FIGS. 1 to 13C).

The flexible circuit board (e.g., 400 of FIGS. 1 to 13C) according to an embodiment of the disclosure may include a second conductive layer (e.g., 446 of FIGS. 1 to 13C) disposed at a position opposite to the first conductive layer (e.g., 442 of FIGS. 1 to 13C) with respect to the base layer (e.g., 441 of FIGS. 1 to 13C).

The flexible circuit board (e.g., 400 of FIGS. 1 to 13C) according to an embodiment of the disclosure may include a second shielding layer (e.g., 449 of FIGS. 1 to 13C) spaced apart from the second conductive layer (e.g., 446 of FIGS. 1 to 13C) and coupled to the first ground layer (e.g., 471 of FIGS. 1 to 13C).

The second shielding layer (e.g., 449 of FIGS. 1 to 13C) according to an embodiment of the disclosure may include a 2-1th shielding layer portion (e.g., 4491 of FIGS. 1 to 13C) located in the first rigid portion (e.g., 410 of FIGS. 1 to 13C).

The second shielding layer (e.g., 449 of FIGS. 1 to 13C) according to an embodiment of the disclosure may include a 2-2th shielding layer (e.g., 4492 of FIGS. 1 to 13C) located in the second rigid portion (e.g., 420 of FIGS. 1 to 13C).

The second shielding layer (e.g., 449 of FIGS. 1 to 13C) according to an embodiment of the disclosure may include a 2-3th shielding layer portion (e.g., 4493 of FIGS. 1 to 13C) located in the flexible portion (e.g., 430 of FIGS. 1 to 13C).

The second shielding layer (e.g., 449 of FIGS. 1 to 13C) according to an embodiment of the disclosure may include a first connecting portion (e.g., 4494 of FIGS. 1 to 13C) connecting the 2-1th shielding layer portion (e.g., 4491 of FIGS. 1 to 13C) and the 2-3th shielding layer portion (e.g., 4493 of FIGS. 1 to 13C).

The second shielding layer (e.g., 449 of FIGS. 1 to 13C) according to an embodiment of the disclosure may include a second connecting portion (e.g., 4495 of FIGS. 1 to 13C) connecting the 2-2th shielding layer portion (e.g., 4492 of FIGS. 1 to 13C) and the 2-3th shielding layer portion (e.g., 4493 of FIGS. 1 to 13C).

The flexible circuit board (e.g., 400 of FIGS. 1 to 13C) according to an embodiment of the disclosure may include a first rigid layer (e.g., 451 of FIGS. 1 to 13C) disposed between the first ground layer (e.g., 471 of FIGS. 1 to 13C) and the first shielding layer (e.g., 471 of FIGS. 1 to 13C).

The first ground layer (e.g., 471 of FIGS. 1 to 13C) according to an embodiment of the disclosure may include a first side portion (e.g., 4711 of FIGS. 1 to 13C) covering an end portion of each of the base layer (e.g., 441 of FIGS. 1 to 13C), the first conductive layer (e.g., 442 of FIGS. 1 to 13C), and the first shielding layer (e.g., 445 of FIGS. 1 to 13C).

The electronic device according to an embodiment of the disclosure may further include a first device coupling portion (e.g., 4712 of FIGS. 1 to 13C) extending from the first side portion (e.g., 4711 of FIGS. 1 to 13C) and disposed between the first rigid layer (e.g., 451 of FIGS. 1 to 13C) and the camera assembly (e.g., 307 of FIGS. 1 to 13C).

The flexible circuit board (e.g., 400 of FIGS. 1 to 13C) according to an embodiment of the disclosure may include a first conductive via (e.g., 491 of FIGS. 1 to 13C) connected to the first ground layer (e.g., 471 of FIGS. 1 to 13C).

The first conductive via (e.g., 491 of FIGS. 1 to 13C) according to an embodiment of the disclosure may penetrate the base layer (e.g., 441 of FIGS. 1 to 13C), the first conductive layer (e.g., 442 of FIGS. 1 to 13C), and the first shielding layer (e.g., 445 of FIGS. 1 to 13C).

The flexible circuit board (e.g., 400 of FIGS. 1 to 13C) according to an embodiment of the disclosure may include a first adhesive layer (e.g., 443 of FIGS. 1 to 13C) disposed between the first conductive layer (e.g., 442 of FIGS. 1 to 13C) and the first shielding layer (e.g., 445 of FIGS. 1 to 13C).

The flexible circuit board (e.g., 400 of FIGS. 1 to 13C) according to an embodiment of the disclosure may include a first cover layer (e.g., 444 of FIGS. 1 to 13C) disposed between the first adhesive layer (e.g., 443 of FIGS. 1 to 13C) and the first shielding layer (e.g., 445 of FIGS. 1 to 13C).

The flexible circuit board (e.g., 400 of FIGS. 1 to 13C) according to an embodiment of the disclosure may include a first rigid body (e.g., 453 of FIGS. 1 to 13C) disposed between the first conductive layer (e.g., 442 of FIGS. 1 to 13C) and the first ground layer (e.g., 471 of FIGS. 1 to 13C).

The flexible circuit board (e.g., 400 of FIGS. 1 to 13C) according to an embodiment of the disclosure may include a second conductive layer (e.g., 446 of FIGS. 1 to 13C) disposed at a position opposite to the first conductive layer (e.g., 442 of FIGS. 1 to 13C) with respect to the base layer (e.g., 441 of FIGS. 1 to 13C).

The flexible circuit board (e.g., 400 of FIGS. 1 to 13C) according to an embodiment of the disclosure may include a second shielding layer (e.g., 549 of FIGS. 1 to 13C) spaced apart from the second conductive layer (e.g., 446 of FIGS. 1 to 13C).

The flexible circuit board (e.g., 400 of FIGS. 1 to 13C) according to an embodiment of the disclosure may include a third ground protrusion (e.g., 575 of FIGS. 1 to 13C) protruding from the first ground layer (e.g., 471 of FIGS. 1 to 13C) and at least partially surrounded by the second shielding layer (e.g., 549 of FIGS. 1 to 13C).

The 1-1th shield layer portion (e.g., 6451 of FIGS. 1 to 13C), the 1-2th shield layer portion (e.g., 6452 of FIGS. 1 to 13C), and the 1-3th shield layer portion (e.g., 6453 of FIGS. 1 to 13C) according to an embodiment of the disclosure may be arranged side by side.

A flexible circuit board (e.g., 400 of FIGS. 1 to 13C) according to an embodiment of the disclosure may include a base layer (e.g., 441 of FIGS. 1 to 13C) extending to correspond to each of a first rigid portion (e.g., 410 of FIGS. 1 to 13C), a second rigid portion (e.g., 420 of FIGS. 1 to 13C) spaced apart from the first rigid portion (e.g., 410 of FIGS. 1 to 13C), and a flexible portion (e.g., 430 of FIGS. 1 to 13C) connecting the first rigid portion (e.g., 410 of FIGS. 1 to 13C) and the second rigid portion (e.g., 420 of FIGS. 1 to 13C).

While the disclosure has been shown and described with reference to exemplary embodiments thereof, it will be apparent to those of ordinary skill in the art that various changes in form and detail may be made thereto without departing from the spirit and scope of the disclosure as defined by the following claims.

## Claims

1. An electronic device (101) comprising:
a housing (301);
a circuit board (340) disposed in the housing (301);
a camera assembly (307) comprising a camera, and spaced apart from the circuit board (340); and
a flexible circuit board (400) including a first rigid portion (410) connected to the camera assembly (307), a second rigid portion (420) connected to the circuit board (340) and a flexible portion (430) connecting the first rigid portion (410) and the second rigid portion (420),
wherein the flexible circuit board (400) comprises:
a base layer (441);
a first conductive layer (442) coupled to the base layer (441);
a first shielding layer (445) including a 1-1th shielding layer portion (4451) located in the first rigid portion (410), a 1-2th shielding layer portion (4452) located in the second rigid portion (420) and a 1-3th shielding layer portion (4453) located in the flexible portion (430), and spaced apart from the first conductive portion (442); and
a first ground layer (471), wherein at least a portion of the first ground layer (471) extends along a circumference of the first rigid portion (410), and the first ground layer (471) is connected to the first shielding layer (445).

2. The electronic device of claim 1,
wherein the flexible circuit board (400) comprises:
a first ground protrusion (473) protruding from the first ground layer (471), and disposed between the first ground layer (471) and the first shielding layer (445).

3. The electronic device of claim 2,
wherein the first shielding layer (445) includes:
an extending portion (4451a) spaced apart from the first ground layer (471); and
a bending portion (4451b) connecting the extending portion (4451a) and the first ground layer (471) and disposed around at least a portion of the first ground protrusion (473).

4. The electronic device of any one of claims 1 to 3,
wherein the flexible circuit board (400) further comprises:
a second ground layer (472) extending along a circumference of the second rigid portion (420), and connected to the first shielding layer (445).

5. The electronic device of claim 4,
wherein the flexible circuit board (400) comprises:
a second ground protrusion (474) protruding from the second ground layer (472), disposed between the second ground layer (472) and the first shielding layer (445).

6. The electronic device of any one of claims 1 to 5,
wherein the flexible circuit board (400) further comprises:
a second conductive layer (446) disposed opposite to the first conductive layer (442) with respect to the base layer (441); and
a second shielding layer (449) spaced apart from the second conductive layer (446), and coupled to the first ground layer (471).

7. The electronic device of claim 6,
wherein the second shielding layer (449) includes:
a 2-1th shielding layer portion (4491) located in the first rigid portion (410);
a 2-2th shielding layer portion (4492) located in the second rigid portion (420);
a 2-3th shielding layer portion (4493) located in the flexible portion (430);
a first connecting portion (4494) connecting the 2-1th shielding layer portion (4491) and the 2-3th shielding layer portion (4493); and
a second connecting portion (4495) connecting the 2-2th shielding layer portion (4492) and the 2-3th shielding layer portion (4493).

8. The electronic device of any one of claims 1 to 7,
wherein the flexible circuit board (400) further comprises:
a first rigid layer (451) disposed between the first ground layer (471) and the first shielding layer(445).

9. The electronic device of claim 8,
wherein the first ground layer (471) includes:
a first side portion (4711) covering each of edges of the base layer (441), the first conductive layer (442) and the first shielding layer (445); and
a first device coupling portion (4712) extending from the first side portion (4711), and disposed between the first rigid layer (451) and the camera assembly (307).

10. The electronic device of any one of claims 1 to 9,
wherein the flexible circuit board (400) further comprises:
a first conductive via (491) connected to the first ground layer (471).

11. The electronic device of claim 10,
wherein the first conductive via (491) penetrates the base layer (441), the first conductive layer (442) and the first shielding layer (445).

12. The electronic device of any one of claims 1 to 11,
wherein the flexible circuit board (400) comprises:
a first adhesive layer (443) disposed between the first conductive layer (442) and the first shielding layer (445); and
a first cover layer (444) disposed between the first adhesive layer (443) and the first shielding layer (445).

13. The electronic device of any one of claims 1 to 12,
wherein the flexible circuit board (400) further comprises:
a first rigid body (453) disposed between the first conductive layer (442) and the first ground layer (471).

14. The electronic device of any one of claims 1 to 13,
wherein the flexible circuit board (400) further comprises:
a second conductive layer (446) disposed opposite to the first conductive layer (442) with respect to the base layer (441);
a second shielding layer (549) spaced apart from the second conductive layer (446); and
a third ground protrusion (575) protruding from the first ground layer (471), and wherein at least a portion of the third ground protrusion (575) is surrounded by the second shielding layer (549).

15. The electronic device of any one of claims 1 to 14,
wherein the 1-1th shielding layer portion (6451), the 1-2th shielding layer portion (6452) and the 1-3th shielding layer portion (6453) are arranged in a parallel direction each other.
